# EUROPEAN PATENT APPLICATION

(11) **EP 4 625 136 A1**
(43) Date of publication of application: **01.10.2025**
(21) Application number: 25166143.5
(22) Date of filing: 25.03.2025
(51) Int. Cl.: G06F 3/12, G06F 7/36

(54) **A METHOD OF DETERMINING A LAYOUT FOR IMAGING A RELIEF PRECURSOR, TAKING INTO ACCOUNT A TOTAL AMOUNT OF IMAGING TIME**

(30) Priority: 25.03.2024 NL 2037324
(71) Applicant: XSYS Prepress NV, 8900 Ieper (BE)
(72) Inventor: VERVAECKE, Johan, 8900 IEPER (BE)
(74) Representative: Arnold & Siedsma

(57) **Abstract**

A method of determining at least one layout for imaging at least one relief precursor (6), comprising:
- receiving image job data for at least one image job comprising at least two raster image files (10; 20) having at least two different resolutions (R1, R2) and/or at least two different quality settings requiring different imaging modes;
- determining, using processing means, at least one layout including the image job data for imaging at least one mask layer of the at least one relief precursor (6), taking into account a total amount of imaging time required to image the at least one mask layer.

## Description

### Field of Invention

The field of the invention relates to methods and computer programs for determining at least one layout for imaging at least one relief precursor.

### Background

When determining the layout of received image job data, typically including at least two raster image files, for imaging at least a relief precursor, a classical way is to arrange the raster image files in a scanning manner. The raster image files are first arranged one by one in a first direction. When the space in the first direction of the precursor is no longer able to receive the next raster image file, the arrangement moves in a second direction (typically perpendicular to the first direction), and then the raster image files are again arranged one by one in the first direction of the relief precursor.

However, this way of determining the layout is not entirely satisfactory. It may lead to a high amount of a precursor that does not contain any raster image file, which goes to waste. Further, it may take a long time to image the mask layer according to the layout thus determined.

WO 2009/099541 A2 discloses a method of determining the layout of a relief precursor. At each event that the user selects a new independent slug 11 (the independent slugs include a single image each) or alters the slug selection, the cost calculator 14 will automatically calculate and display the computed cost results, to reflect changes made by the user. The cost configuration setup 13 includes among other parameters: fully loaded cost per square inch or mm for plates, fully loaded cost per square inch to manufacture each carrier, and fully loaded costs "per mount" to position and edge sealed slug plates. Thus, the invention in WO 2009/099541 helps the user reach the most cost effective slugs selection that is optimized to his or her specific needs, taking into account parameters such as plate cost, cost of labor, and other relevant cost related parameters.

However, the new images are selected manually by a user. The determination of the layout is not automated.

### Summary

Embodiments of the present disclosure are based on the insight that where two raster image files have two different resolutions or two different quality settings requiring different imaging modes, the resolutions and/or the qualify settings introduce another variable that needs to be taken into account compared to when the raster image files to be put on a relief precursor have the identical resolution and the identical quality settings. Furthermore, different customers can have different factors of consideration in mind when the layout is decided, so even if the same raster image files need to be arranged on the same relief precursors, different layouts are possible.

In another situation, when determining the layout one factor of consideration can be how to reduce the area of a relief precursor which will not contain imaging pixels, as it typically goes to waste. However, as raster image files have fixed sizes, once it is known which raster image files need to go on a relief precursor, it is not obvious how to reduce the waste portion of this relief precursor further.

One objective of the present disclosure is to optimise the layout of image job data for imaging at least one relief precursor when there are at least two raster image files having different resolutions and/or different quality settings. One objective of the present disclosure is to reduce the portion of the relief precursors that goes to waste.

According to a first aspect, there is provided a method of determining at least one layout for imaging at least one relief precursor. The method comprises receiving image job data for at least one image job comprising at least two raster image files. The at least two raster image files have at least two different resolutions and/or at least two different quality settings requiring different imaging modes. The method also comprises determining, using processing means, at least one layout including the image job data for imaging at least one mask layer of the at least one relief precursor, taking into account a total amount of imaging time required to image the at least one mask layer.

When there are two raster image files having two different resolutions and/or two different quality settings, the imaging settings need to be changed, and the imaging takes longer than when the raster image files only have one resolution. By taking into account the total amount of imaging time when determining the layout, the layout can reduce the additional time that the complexity of more than one resolution and/or more than one imaging mode may bring into the imaging process. Typically there is a relative motion of the imaging head in a first direction and in a second direction relative to the relief printing precursor. The first direction typically corresponds to an imaging direction. The second direction typically corresponds to a row direction perpendicular to the imaging direction.

Preferably, determining the at least one layout comprises preferring a first direction, typically the imaging direction to arrange raster image files having the same resolution and/or same quality setting to a second direction, typically the row direction. During the imaging, the imaging head moves in the imaging direction perpendicular to the row direction, such that an area can be covered by the imaging head in a single pass. Depending on the width of a raster image file, multiple passes would be needed to image it: after the first pass of the imaging head, the imaging head moves in the row direction and makes another pass in the imaging direction, etc..

Often the relative motion of the imaging heads is faster in one direction than in another direction, for example faster in the imaging direction than in the row direction. By preferring one direction to arrange the raster image files, the imaging of the raster image files having the same resolution and/or the same quality setting can be accelerated.

As an example, the imaging heads may move in a fast imaging direction and a slow imaging direction. For example, using N beams, N tracks of pixel locations may be written simultaneously, when the N beams move in the fast imaging direction. The beams extend next to each other in the slow imaging direction. An example of the fast and slow imaging directions is given in WO 2018/228922 A1. Here, the fast imaging direction corresponds to the imaging direction (such as the rotating direction of the drum on which the precursor is fixed), and the slow imaging direction corresponds to the row direction. By preferring the fast imaging direction to arrange the raster image files having the same resolution to the slow imaging direction, the imaging of at least one relief precursor can be accelerated.

Optionally, the imaging direction is approximately perpendicular to the row direction.

Optionally, the imaging direction is the circumferential direction of a drum on which the relief precursor is fixed during imaging.

In this case, the row direction may be the length direction of the drum which is perpendicular to the circumferential direction.

Optionally, determining the at least one layout further comprises taking into account the number of relief precursors needed to fit the image job data.

In some cases it is preferable to control the number of the relief precursors for the image job(s). By taking into account the number of relief precursors needed to fit the image job data, the raster image files may be organised on the relief precursors in such a way that the total number of the relief precursors to be imaged is capped or reduced.

Optionally, determining the at least one layout further comprises taking into account whether raster image files on a same relief precursor belong to the same image job of said at least one image job.

Even with the same imaging settings, the same imaging heads may produce slightly different imaging results on two different relief precursors, especially when the interval between the imaging of the two relief precursors is long. When an area imagined from a part of the first relief precursor needs to be superimposed with an area imaged from a part of the second relief precursor, these two areas may not be aligned as required, for example when the part of the first relief precursor corresponds to a first colour and the part of the second relief precursor corresponds to a second colour which are to be combined to produce a colour picture. By arranging the raster image files belonging to the same image job on the same relief precursor this potential inconsistency can be reduced.

Furthermore, the management of an image job is simplified. For instance, an image job may comprise two raster image files, with the first raster image file placed on a first precursor and the second raster image file placed on a second precursor. It is possible that the interval between the manufacturing of the two precursors is long: while the first precursor may be imaged, exposed, washed, and dried before 10am, the second precursor may not be imaged until 6pm of the same day. The customer would have to wait for the second precursor to finish the image job, even if the rest of his image job is already ready much earlier. By taking into account whether raster image files on a same relief precursor belong to the same image job, an image job can be finished earlier. Moreover, it is easier to keep track of unfinished parts of an image job.

Optionally, determining the at least one layout further comprises taking into account a priority or a deadline of an image job of said at least one image job.

It may be needed to escalate the priority of an image job so that the image job can be finished before a certain deadline. By taking into account a priority or a deadline, the corresponding image job data may be placed on a relief precursor which will be imaged earlier.

Optionally, determining the at least one layout comprises minimising the total amount of imaging time required to image the at least one mask layer.

This can shorten the total imaging time, thus accelerating the manufacturing process of relief precursors.

Optionally, determining the at least one layout comprises using weight factors for two or more of the following criteria: a total amount of imaging time required to image the at least one mask layer, the number of relief precursors needed to fit the image job data, whether raster image files on a same relief precursor belong to the same image job of said at least one image job, a priority or a deadline of an image job of said at least one image job, or an amount of waste.

Determining the layout may be subject to different and sometimes conflicting preferences. For instance, if the priority of an image job is given preference to, the total amount of imaging time may be longer or the number of relief precursors may be higher. As another example, if one wants to reduce the number of relief precursors needed to fit the image job data, the raster image files on the same relief precursor may not belong to the same image job.

Furthermore, even for the same image job data two different customers may want to obtain different layouts: the first one may want to minimise the total amount of imaging time and the second one may want to minimise the number of relief precursors to fit the image job data.

By using weight factors for these criteria, different preferences can be taken into consideration. The layout for the same image job can be flexibly adjusted according to various requirements.

Optionally, at least one of the weight factors is input to the processing means through a user interface.

Thanks to this feature, a user may tell the processing means how much weight he wants to give to a certain criterion. For example, he can indicate that 90% of the consideration will be given to the number of relief precursors, and the rest 10% will be divided evenly amongst the remaining criteria. As another example he may indicate that 50% of the consideration will be given to the total amount of imaging time, 20% to the number of relief precursors, 20% to arranging the raster image files on the same relief precursor belonging to the same image job, and the remaining 10% to the priority or the deadline of a certain image job.

Optionally, the method comprises:
- determining at least two different possible layouts including all of said image job data;
- allocating a score for each determined layout taking into account the weight factors;
- choosing the layout having the highest score as the layout for imaging the at least one mask layer.

It is thus possible to choose a layout according to different requirements, reflected in different sets of weight factors. By choosing the layout having the highest score, the preference indicated in the weight factors is taken into account.

Each score for example corresponds to a set of weight factors.

According to a preferred embodiment, the method further comprises modifying the algorithm used to determine the at least one layout.

The method may use a neural network. Modifying the algorithm for example comprises training the neural network and modifying the weights in the neural network. During the training, the neural network is fed with raster image files and a set of weight factors as inputs. The neural network outputs a score determined based on the raster image files and the set of weight factors. The neural network is trained so that it outputs, for the raster image files and the set of weight factors, at least one layout with the highest score(s). This for instance involves adjusting the weights of the neural network so that the score from the same raster image files and the set of weight factors is maximised. The process is then repeated, both with the same raster image files but with a different set of weight factors, and with different raster image files.

An improved neural network can be thus obtained.

Optionally, the determining is done such that a total area taken up by the raster image files on each mask layer of the at least one relief precursor is at least 60%, preferably more than 70%, more preferably more than 80% of the entire printable area of said mask layer.

Thanks to this feature, the portion of the at least one relief precursor that goes to waste is reduced.

Optionally, determining the layout further comprises arranging the raster image files of the same image job on at least one pre-determined relief precursor.

In this way, additional variation that may be introduced by a relief precursor can be taken into account and/or reduced. In this manner inconsistency in the imaging result of the same image job may be lowered.

Optionally, the at least one pre-determined relief precursor is a single relief precursor or a number of consecutive relief precursors imaged one after the other.

Putting the raster image files of the same image job on the same relief precursor or a number of consecutive relief precursors makes sure that variation in the imaging result due to different relief precursors is reduced and even eliminated.

Optionally, the method further comprises imaging the mask layer of a relief precursor according to the determined layout, wherein a first imaging head emitting at least one first ablation beam according to a first imaging mode and a second imaging head emitting at least one second ablation beam according to a second imaging mode different from the first imaging mode image the mask layer of the relief precursor simultaneously.

With the ablation beams according to two different modes imaging a mask layer simultaneously, the imaging time of two areas having two different resolutions and/or two different quality settings can be reduced. For example, it would no longer be necessary to image the area having the first resolution on earlier passes, and then, to image the area having the second resolution different to the first resolution on subsequent passes.

In addition or alternatively, the method further comprises imaging the mask layer of a relief precursor according to the determined layout, wherein the imaging head emitting at least one first ablation beam according to a first imaging mode and/or having a first size corresponding to a first resolution image the mask layer on a first pass of the imaging head, and the same imaging head emitting at least one second ablation beam according to a second imaging mode different from the first imaging mode and/or having a second size corresponding to a second resolution different from the first resolution image the mask layer on a second pass of the imaging head.

Optionally, the imaging mode defines at least one of the following properties: an intensity of the at least one laser beam, a shape of the at least one laser beam, a size of the at least one laser beams.

According to a second aspect, there is provided a method of determining at least one layout for imaging at least one relief precursor. The method comprises receiving image job data for at least one image job comprising a plurality of raster image files. The method also comprises determining, using processing means, at least one layout including the image job data for imaging at least one mask layer of the at least one relief precursor, comprising overlapping at least two of the plurality of raster image files in the layout.

When determining the layout for imaging the at least one mask layer, typically two raster image files are kept distinct without overlaps. However, not the entire areas on the relief printing plate corresponding to the raster image files are used for printing. By overlapping at least two of the raster image files in the layout, the area of the relief printing plate which is not used for printing can be reduced.

Optionally, the image job data comprises at least two indication raster image files having a cutting mark associated with the at least two raster image files, wherein the method comprises taking into account the cutting marks for determining the at least one layout. Preferably it is avoided that cutting marks of the at least two indication raster image files cross one another. In another embodiment the cutting marks are directly included in the at least two raster image files. Also in such embodiment, the determining may be done such that cutting marks do not cross one another.

For separating two image zones of the relief printing plate it is possible to use cutting marks and/or cutting contours. The cutting mark is normally a line or a set of lines that is used for manually separating the image zones. The cutting contour is a shape, often irregular, that should be followed by an automated cutting table. By taking into account the cutting marks, the cutting marks can be kept distinct so later separation can be carried out effectively.

Optionally, the cutting mark is included in the raster image file.

Optionally, the at least two raster image files comprises a first raster image file having at least one image area comprising imaging pixels and at least one non-image area comprising non-imaging pixels, and a second raster image file having at least one image area comprising imaging pixels, wherein overlapping the at least two raster image files in the layout comprises avoiding overlapping the image area of the second raster image file with the non-image area of the first raster image file.

The part of the relief printing plate corresponding to the non-image area can be subject to additional processing during the production of the relief plate, for example the non-image area corresponds to where the image zones (corresponding to the image areas of the first and second raster image files) of a relief printing plate are separated after the relief precursor is exposed and developed. By not overlapping the image area of a raster image file with a non-image area of another raster image file, potential damage to image zones of a relief printing plate, which zones correspond to the image areas, can be avoided.

According to one embodiment there is a non-functional area outside the image area I. The non-functional area includes imaging pixels added in this area. The non-functional area is for example as disclosed in European patent application EP23199621.6. According to some embodiments determining the layout comprises taking into account the imaging pixels added into the non-functional area, as different patterns of filling pixels in the non-functional area may lead to different total amount of imaging time etc..

Optionally, the cutting mark is located at an edge of an image area of said at least one image area.

Optionally, the at least one non-image area comprises a border surrounding the at least one image area.

By keeping the image area of a raster image file off the border, one can be sure that the image areas of two raster image files are kept at a distance one from the other after the overlapping.

Optionally the border comprises a cutting mark.

By not putting the image area of a raster image file into the border, potential damage to the image zones of a relief printing plate, which zones correspond to the image areas of the first and the second raster image files, when the image zones are subsequently separated can be avoided.

Optionally, the second raster image file has at least one non-image area comprising non-imaging pixels. The method comprises overlapping the at least two raster image files in the layout comprises overlapping the non-image area of the second raster image file with the non-image area of the first raster image file.

In this manner more image areas can be arranged on the printing area of a relief precursor. The portion of the relief precursor that goes to waste can be thus reduced.

Optionally at least one non-image area comprises a mark, such as the cutting mark as explained above. In addition or alternatively the mark comprises a registration mark and/or a mounting mark. The registration mark is for example that disclosed in patent application WO 2019/038400 A1. The registration mark is used for example by a cutting table to find out how a plate is positioned on the cutting table. The mounting mark for instance makes sure that a relief plate can be placed on the correct location on a printing cylinder, for example in such a way that its position matches the position of the other plates for different colours.

Alternatively the mark is included in an image area and prints on a printing medium, or is written on the relief plate precursor before or during or after the cutting of the relief plate precursor.

The present disclosure also relates to a flexographic printing plate obtained by the method as described above.

The present disclose also relates to a computer program or computer program product comprising computer executable instructions to control the method described above when the program is run on a computer.

The present discloses also relates to a digital data storage medium encoding a machine-executable program of instructions to perform any one of the steps of the method described above.

Any feature of the first aspect can be combined with any feature of the second aspect.

### Brief description of the figures

The accompanying drawings are used to illustrate presently preferred non-limiting exemplary embodiments of methods, control modules and systems of the present invention. The above and other advantages of the features and objects of the invention will become more apparent and the invention will be better understood from the following detailed description when read in conjunction with the accompanying drawings, in which:
Fig. 1 shows a layout of the raster image files on a relief plate precursor according to a method under the first aspect of the present disclosure, where the layout is determined taking into account the total amount of imaging time required to image the at least one mask layer;
Fig. 2 shows a layout of the raster image files on a relief plate precursor according to a method under the first aspect of the present disclosure, where the layout is determined taking into account the number of relief precursors needed to fit the image job data;
Fig. 3 shows an variation of the layout in Fig. 2;
Fig. 4 shows a layout of the raster image files on two relief plate precursors according to a method under the first aspect of the present disclosure, where the layout is determined taking into account a priority or a deadline of an image job;
Fig. 5 shows a layout of the raster image files on two relief plate precursors according to a method under the first aspect of the present disclosure, where the layout is determined taking into account whether raster image files on a same relief precursor belong to the same image job;
Fig. 6 shows a layout of the raster image files on a relief plate precursor according to a method under the second aspect of the present disclosure;
Fig. 7 shows a layout of the raster image files on a relief plate precursor according to a method under the second aspect, showing avoiding overlapping the cutting mark;
Fig. 8 shows a layout of the raster image files on a relief plate precursor according to a method under the second aspect of the present disclosure, comprising avoiding overlapping an image area of the second raster image file with the border of an image area of the first raster image file, the border presenting a non-image area of the first raster image file;
Fig. 9 shows a layout of the raster image files on a relief plate precursor according to a method under the second aspect of the present disclosure, comprising overlapping the borders of the first and second raster image files, the borders presenting some of the non-image areas;
Fig. 10 shows an exemplary embodiment of a system according to the invention.

### Detailed description of embodiments

Flexographic printing or letterpress printing are techniques which are commonly used for high volume printing. Flexographic or letterpress printing plate are relief plates with printing elements, typically called reliefs or dots, protruding above non-printing elements in order to generate an image on a recording medium such as paper, cardboard, films, foils, laminates, etc. Also, cylindrically shaped printing plates or sleeves may be used.

Various methods exist for making flexographic printing plate precursors. According to conventional methods, flexographic printing plate precursors are made from multilayer substrates comprising a backing layer and one or more photocurable layers (also called photosensitive layers). Those photocurable layers are imaged by exposure to electromagnetic radiation through a mask layer containing the image information or by direct and selective exposure to light e.g. by scanning of the plate to transfer the image information in order to obtain a relief plate.

The relief precursor is for example a digital relief precursor or an analogue relief precursor. In case of a digital relief precursor the mask layer is an integral layer of the precursor, and the imaging of the mask layer results in an ablated layer, whereas in case of an analogue relief precursor the mask layer is typically a separate layer, such as a film, which comprises areas which are transparent for radiation and areas which are not transparent for radiation, and which is mounted onto the relief precursor prior to exposure with electromagnetic radiation. For example, a non-transparent ablatable layer on a substrate layer may be used and the structures may be generated by ablation, or the transmission of a layer of a film may be changed by exposure with a laser.

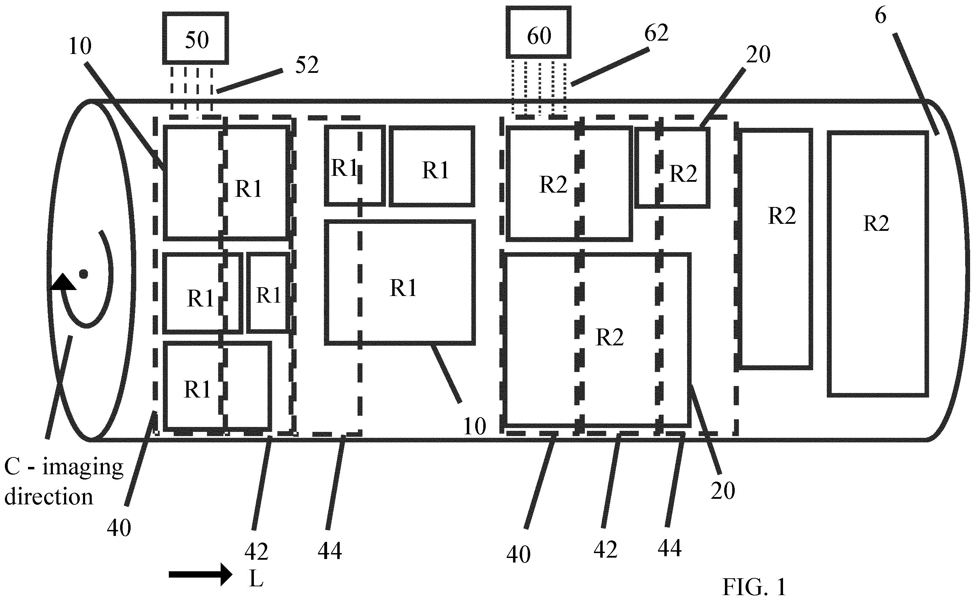

Fig. 1 shows the layout of the relief plate precursor 6 including the image job data for imaging the mask layer of the relief precursor 6. The image job data comprise at least two raster image files 10, 20 having at least two different resolutions R1, R2.

In Fig. 1 the relief plate precursor 6 is fixed on a drum for the imaging. The drum defines an imaging direction C and a row direction L. The row direction L is for example the longitudinal direction of the drum parallel to the rotation axis of the drum. The imaging direction C is for example the circumferential direction of the drum.

In the example in Fig. 1, the mask layer is imaged in at least two passes. During the first pass, the first pass zone 40 of the mask layer is imaged. The first pass zone 40 corresponds to an area covered by one pass of an imaging head in the imaging direction C. The first pass zone 40 has a dimension in the row direction L, which corresponds to the imaging width of the corresponding imaging head. The first pass zone 40 has a dimension in the imaging direction C less than or equal to the circumference of the drum. Fig. 1 shows two first pass zones 40 each corresponding to an imaging head 50, 60.

During the second pass subsequent to the first pass, the second pass zone 42 is imaged. The second pass zone 42 is located downstream in the row direction C relative to the corresponding first pass zone 40. The second pass zone 42 may preferably have the same dimension in the row direction L as that of the corresponding first zone 40, or they may be different.

The similar description applies for the third pass zone 44, fourth pass zone (not shown in the Figures) etc..

The imaging direction C for example corresponds to the fast imaging direction. The row direction L for example corresponds to the slow imaging direction.

The layout is determined taking into account the total amount of imaging time required to image the at least one mask layer, for example in order to minimise the total amount of imaging time required to image the at least one mask layer. According to the embodiment illustrated in Fig. 1, determining the layout comprises preferring the imaging direction C to arrange the raster image files 10, 20 having the same resolution to the row direction L.

According to some preferred embodiments, when the mask layer of the relief precursor 6 is imaged according to the determined layout, the imaging uses at least two different imaging heads 50, 60, as seen in Fig. 1. The first imaging head 50 emits at least one first ablation beam 52 according to a first imaging mode M1. The second imaging head 60 emits at least one second ablation beam 62 according to a second imaging mode M2 different from the first imaging mode M1. The first imaging head 50 and the second imaging head 60 image the mask layer of the relief precursor 6 simultaneously.

The imaging mode M1, M2 defines at least one of the following properties: an intensity of the at least one laser beam, a shape of the at least one laser beam, a size of the at least one laser beams, the total number of laser beams used during a pass, scrambling.

Without scrambling one may obtain straight edges between imaging strips. This may result in a visible dust line at strip edges. This may not be acceptable in certain cases, for example for jobs requiring a high quality. A method to avoid the so called "dust lines" is scrambling. With scrambling one randomly images pixels at the edge of an imaging strip either in the previous strip or in the current strip so that two strips fit into each other, for example in a complementary way like a puzzle. For this, the strips need to overlap. The number of overlapping pixels is a parameter for scrambling. In addition or alternatively, one may change the frequency of selecting another random value for scrambling (every x number of pixels).

The different size of the at least one ablation beams 50, 60 may be obtained by using different sets of optical lenses. According to a preferred embodiment, the size of the at least one ablation beams, and more generally, the imaging mode, is decided by in which folder a raster image file is located. Each folder defines a different imaging mode.

Alternatively the raster image file may comprise a header which includes information on which size of the ablation beam is to be used for imaging the pixels in the raster image file.

Alternatively the imaging mode for imaging a raster image file is determined by an imaging mode file corresponding to this raster image file.

The imaging mode may further define whether to apply a surface screen pattern in an imaging mode and/or different screen surface patterns in different imaging modes.

The different imaging modes are for example those disclosed in the application WO 2020/188041.

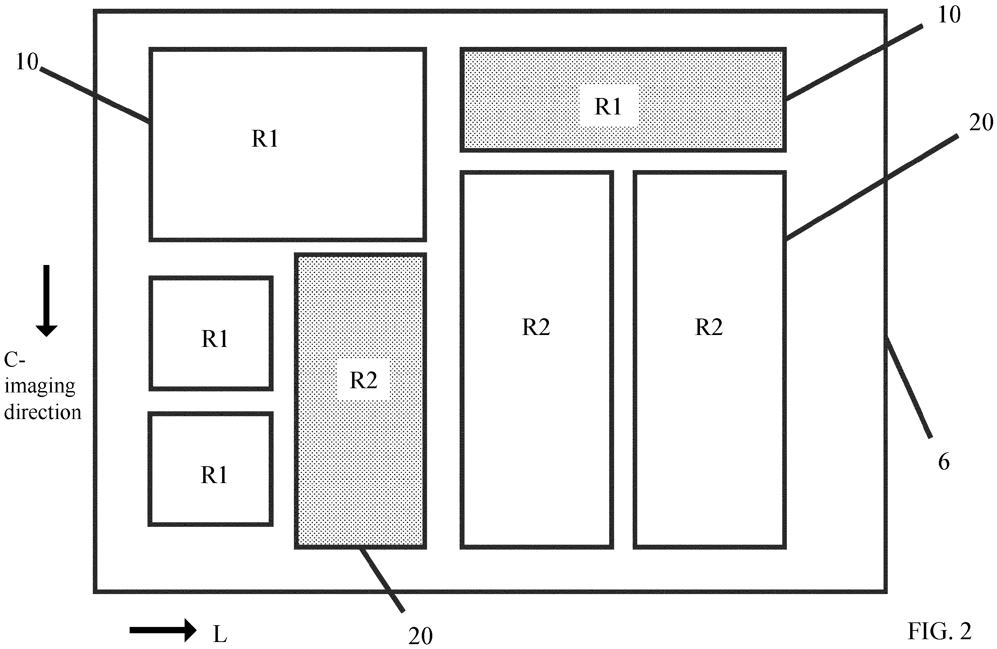

Fig. 2 shows one embodiment when determining the layout takes into account the number of relief precursors 6 needed to fit the image job data. For example, if the only consideration is given to the total amount of imaging time, it may be quicker if the raster image files 10 having the first resolution R1 are arranged on a first relief precursor, and the raster image files 20 having the second resolution R2 are arranged on a second relief precursor. However, this layout may leave a substantial part of the first and/or the second relief precursor empty of any raster image file, which part then goes to waste.

In the embodiment of Fig. 2, the raster image files 10, 20 having the first and second resolutions R1, R2 are arranged such that they can be laid out on the same relief precursor 6. In particular, the position of the shaded raster image files having the first resolution R1 and the second resolution R2 has been adjusted. Some raster image files 20 having the second resolution R2, which would otherwise need to be arranged on a separate relief precursor, can now be arranged, together with some raster image files having the first resolution R1, on one relief precursor.

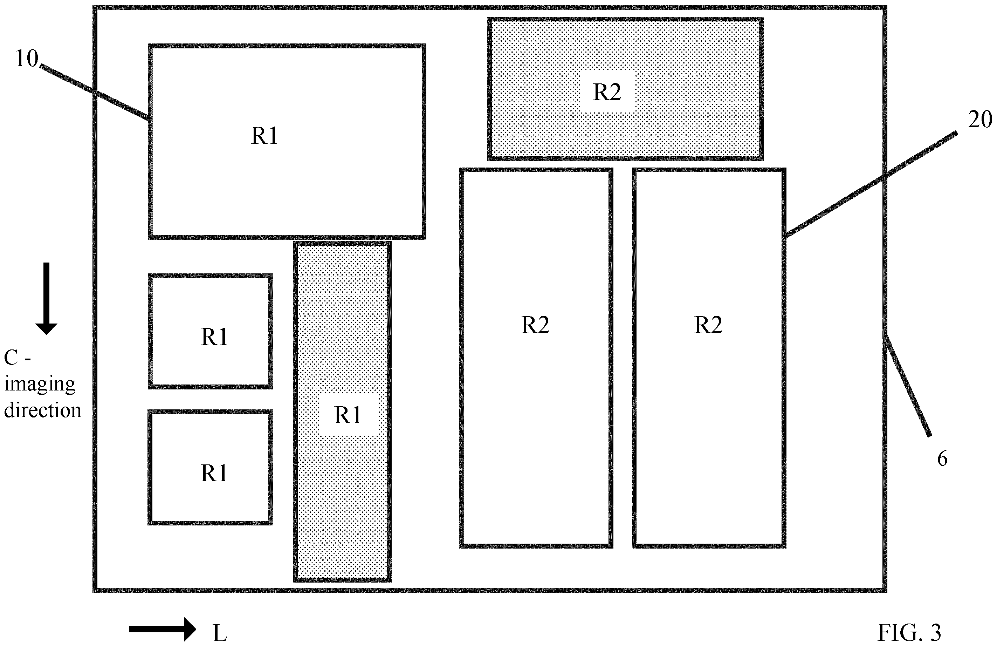

According to an optional embodiment, it is possible to rotate a raster image file before it is arranged on a relief plate precursor. For example, in Fig. 2 it may be possible to rotate the shaded raster image files having the first resolution R1 and having the second resolution R2 for 90°. These two raster image files can then be swapped such that the raster image files 10 having the first resolution R1 are located in a first zone of the mask layer which can be imaged by an imaging head and the raster image files 20 having the second resolution R2 are located in a second zone of the mask layer downstream of and separate from the first zone which can be imaged by another imaging head. The modified layout is shown in Fig. 3. The layout in Fig. 3 can in particular further reduce the imaging time of the relief precursor compared to the layout in Fig. 2.

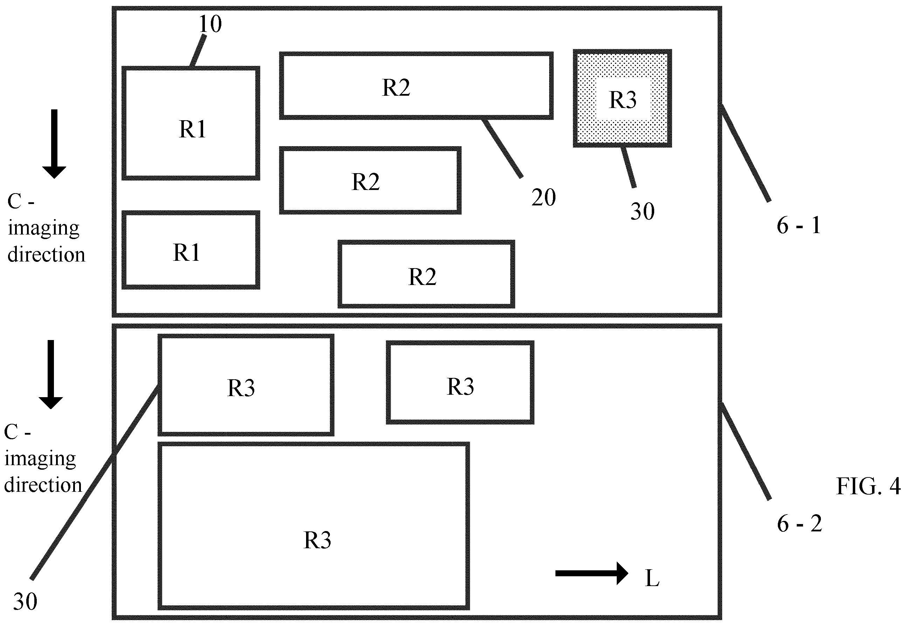

Fig. 4 illustrates one embodiment when determining the layout takes into account the priority or the deadline of an image job. The shaded raster image file 30 having the third resolution R3 corresponds to an image job having a higher priority than the other raster image files 30 having the third resolution R3 which are not shaded.

The layout of the first relief precursor 6 - 1 includes at least one raster image file having the first resolution R1 and/or at least one raster image file having the second resolution R2. The at least one raster image file having the first resolution R1 and/or having the second resolution R2 has a higher priority than the raster image files having the third resolution R3 which are not shaded. In the case of Fig. 4, without taking the priority of an image job into account, it may take less total imaging time and/or produce less waste of the relief precursor if all the raster image files 30 having the third resolution R3 are arranged on the second relief precursor 6 - 2. However, because the shaded image file 30 having the third resolution R3 has a higher priority it is arranged instead on the first relief precursor 6 - 1. In this way an image file 30 can be imaged earlier than the other image files 30 having the same resolution. The relief printing plate having a printing area corresponding to this image file can be ready for printing earlier than the printing areas corresponding to other image files.

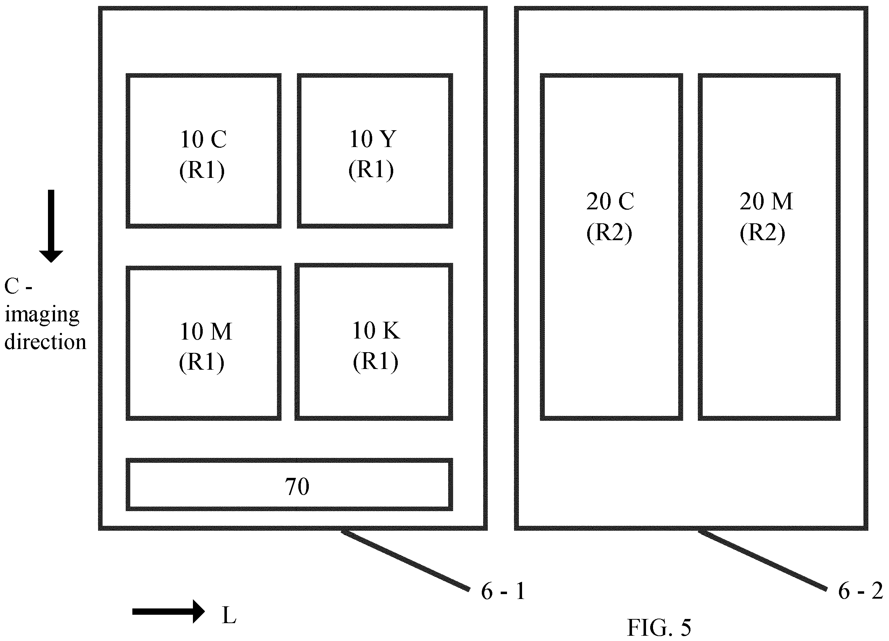

Fig. 5 shows one embodiment when determining the layout takes into account whether the raster image files on the same relief precursor belong to the same image job. In the example in Fig. 5, the raster image files 10C, 10M, 10Y, 10K, 70 belonging to the first image job are arranged on the first relief precursor 6 - 1, and the raster image files 20C, 20M belonging to the second image job are arranged on the second relief precursor 6 - 2. In the example of Fig. 5, at least some of the raster image files 10, for example all the raster image files 10, arranged on the first relief precursor 6 - 1 have the same size and/or the same resolution R1. The raster image files 10 arranged on the first relief precursor 6 - 1 for example each corresponds to one colour of an image job, for instance corresponding to the CMYK colours. Optionally, as shown in Fig. 5, the first relief precursor 6 - 1 also comprises at least an additional raster image file 70 having a different size compared to the other raster image files 10 arranged on the first relief precursor 6 - 1. For example, the additional raster image file 70 comprises a barcode for identifying the image job arranged on the first relief precursor 6 - 1.

The raster image files 20 having the second size and/or the second resolution R2 are arranged on the second relief precursor 6 - 2. The raster image files 20 arranged on the second relief precursor 6 - 2 for example each corresponds to one colour of an image job.

Amongst the four criteria for determining the layout mentioned above, i.e. a total amount of imaging time required to image the at least one mask layer, the number of relief precursors needed to fit the image job data, whether raster image files on the same relief precursor belong to the same image job, a priority or a deadline of an image job, consideration may be given to not only one criterion (thus disregarding the other criteria) but can also be a balancing between different criteria. According to some embodiments determining the at least one layout comprises using weight factors for two or more of these criteria.

According to some embodiments it is possible to modify the weight factors for determining at least two layouts including the same image job data, and/or for determining the layouts for two different image job data. For instance, at least one of the weight factors can be input to the processing means through a user interface according to the need of different customers. Alternatively the weight factors may be fixed.

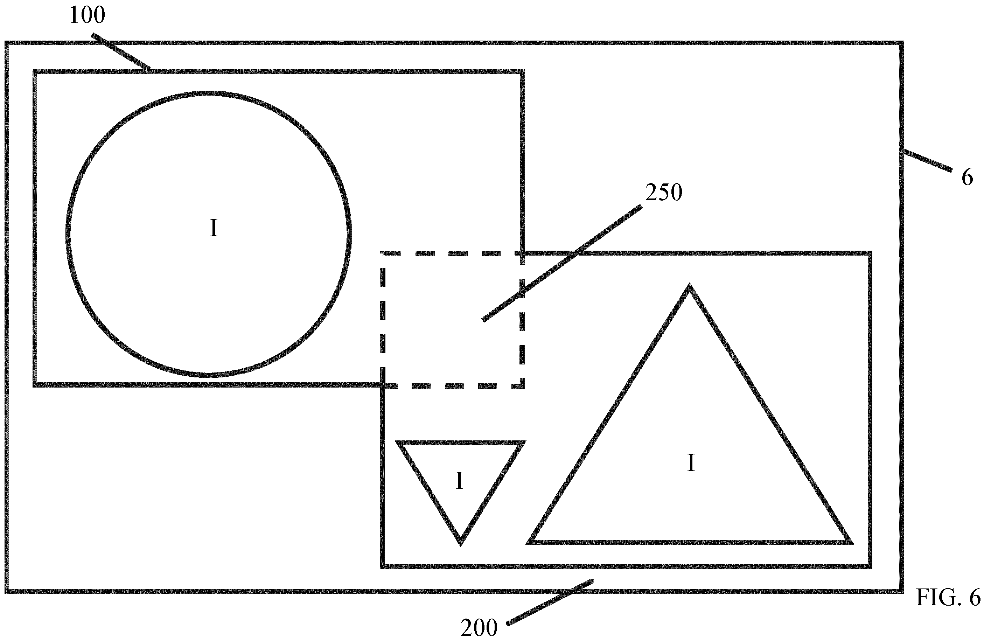

Fig. 6 shows an embodiment according to the second aspect of the present disclosure. The relief precursor 6 has the first raster image file 100 and the second raster image file 200 arranged on it. The raster image files 100, 200 for instance have a rectangular shape. Each raster image file 100, 200 comprises at least one image area I comprising imaging pixels. At least one of the image areas I may not have a rectangular shape. In the examples illustrated in Fig. 6 an image area I has a round shape while another image area I has a triangular shape. The part outside the at least one image area I of the first raster image file 100 overlaps the part outside the at least one image area I of the second raster image file 200, in an overlapping portion 250. According to some embodiments, such as the one shown in Fig. 6, the overlapping portion 250 of the first and second raster image files 100, 200 does not include any imaging pixels.

The imaging head can move more quickly in a zone of the relief precursor corresponding to a non-image area of the raster image file comprising non-imaging pixels than in a zone of the relief precursor corresponding to an image area of the raster image file comprising imaging pixels. According to one embodiment, determining the layout takes into account the increased moving speed of the imaging head. This is because overlapping some imaging pixels of a raster image file in an area with only non-imaging pixels of another raster image file will slow down the moving of the imaging head in this area.

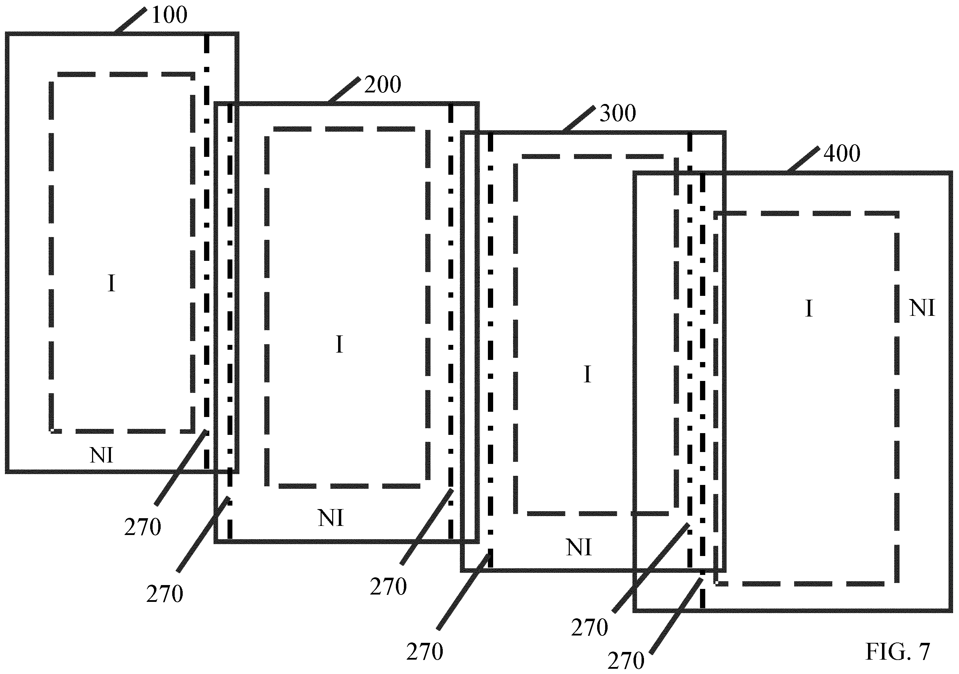

Fig. 7 shows another embodiment according to the second aspect of the present disclosure. This figure shows four raster image files 100, 200, 300, 400. At least one of the raster image files, in the example of Fig. 7 each raster image file comprises at least one image area I comprising imaging pixels and at least one non-image area NI comprising non-imaging pixels. At least one non-image area NI for example at least partially surrounds at least one image area I. As seen in Fig. 7, overlapping the cutting mark is avoided.

The overlapping may comprise overlapping only the non-image area of two raster image files 100, 200. A cutting mark 270 corresponding to a raster image file may overlap a non-image area NI of another raster image file (the cutting mark corresponding to the second raster image file 200 overlaps a non-image area NI of the first raster image file 100), and/or the cutting mark 270 corresponding to a raster image file may not overlap a non-image area NI of another raster image file (the cutting mark 270 corresponding to the first raster image file 100 does not overlap a non-image area NI of the second raster image file 200; the cutting mark corresponding to the second raster image file 200 does not overlap a non-image area NI of the third raster image file 300).

The overlapping may comprise overlapping a non-image area NI of a raster image file with an image area I of another raster image file (a non-image area NI of the fourth raster image file 400 overlaps an image area I of the third raster image file 300; a non-image area NI of the third raster image file 300 overlaps an image area I of the fourth raster image file 400). The cutting mark 270 may or may not overlap a non-image area NI of another raster image file (the cutting mark 270 corresponding to the fourth raster image file 400 overlaps a non-image area NI of the third raster image file 300).

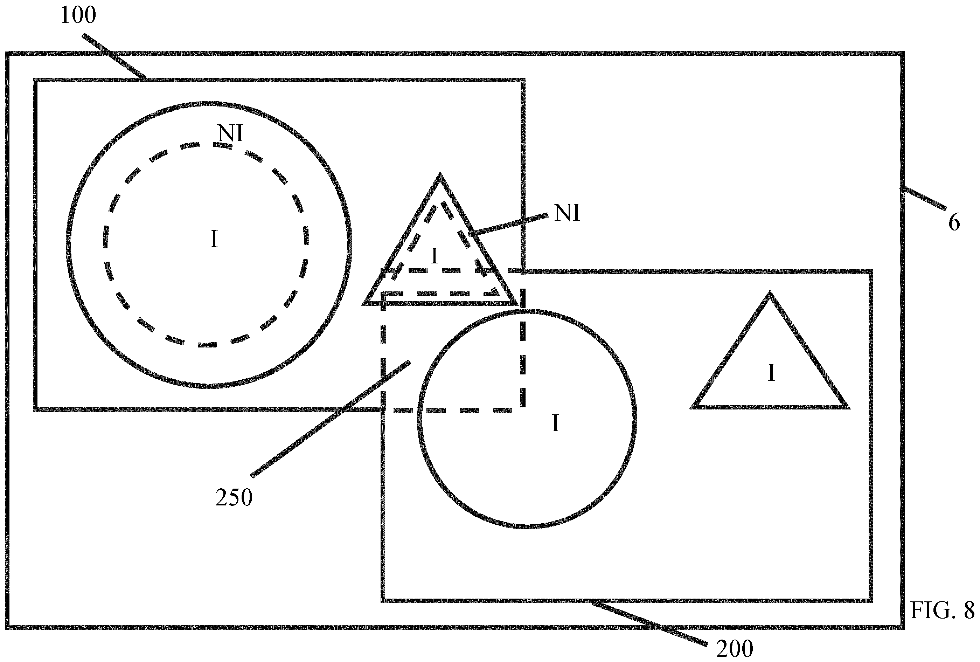

Fig. 8 shows another embodiment according to the second aspect of the present disclosure similar to Fig. 6. The first raster image file 100 has at least one image area I comprising imaging pixels. The first raster image file 100 also has at least one non-image area NI comprising non-imaging pixels. In the example of Fig. 8, at least one non-image area NI is a border at least partially around, for example fully surrounding, an image area I. The second raster image file 200 has at least one image area I comprising imaging pixels. The first raster image file 100 overlaps the second raster image file 200 in the overlapping area 250.

In some embodiments, such as the one illustrated in Fig. 8, overlapping the first and second raster image files 100, 200 in the layout comprises avoiding overlapping an image area I of the second raster image file 200 with a non-image area NI of the first raster image file 100. Regarding the image area I of the first raster image file 100 and/or the second raster image file 200, it may locate partially or fully inside the overlapping area 250, such as shown in Fig. 8, or keeps clear of the overlapping area 250, such as shown in Fig. 6.

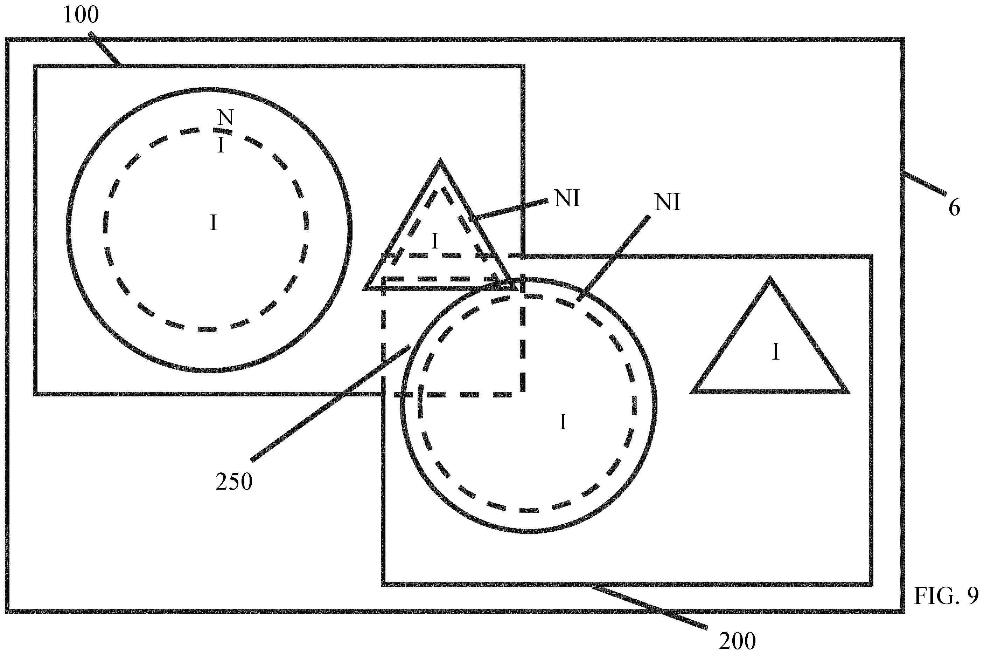

Fig. 9 shows another embodiment according to the second aspect of the present disclosure. The features of Fig. 9, if not mentioned specifically below, are identical to those in Fig. 8.

In this embodiment the second raster image file 200 has at least one non-image area NI comprising non-imaging pixels. The non-image area NI for instance surrounds an image area I of the second raster image file 200. At least one non-image area NI of the second raster image file 200 overlaps at least one non-image area NI of the first raster image file 100. The image area I of the first raster image file 100 does not overlap the image area I of the second raster image file 200. A non-image area NI of the second raster image file 200 may be located partially in the overlapping area 250, such as shown in Fig. 9, or located fully in the overlapping area 250, or does not overlap the overlapping area 250.

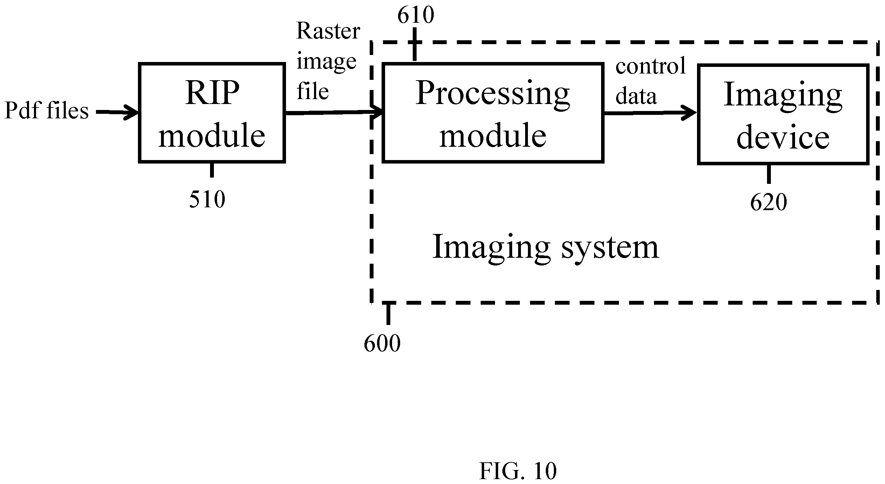

Fig. 10 illustrates an embodiment of a system comprising a raster image processing (RIP) module 510 and an imaging system 600. The imaging system 600 comprises a processing module 610 and an imaging device 620 (e.g. an imager).

The RIP module 510 converts a source image file, here a pdf file, into a raster image file, which is entered into the processing module 610 of the imaging system 600. The RIP module 510 is a component used in image processing which produces a raster image file also known as a bitmap. The source image file may be a page description in a high-level page description language such as PostScript, Portable Document Format, XPS or another bitmap. In the latter case, the RIP applies either smoothing or interpolation algorithms to the input bitmap to generate the output bitmap. Raster image processing is the process of turning e.g. vector digital information such as a PostScript file into a high-resolution raster image file. Usually the RIP module 510 is implemented either as a software component of an operating system or as a firmware program executed on a microprocessor.

The RIP module 510 has a layout function which determines at least one layout for imaging at least one relief precursor. The layout is determined according to an embodiment of the present disclosure. The RIP module 510 is configured to generate a combined raster image file which comprises raster image files arranged according to the determined layout. The RIP module 510 comprises a memory configured to store the combined raster image file. The RIP module 510 is configured to send the combined raster image file to the imaging system 600, for example to the imaging device 620, for imaging the mask layer of a relief plate precursor.

According to one embodiment the combined raster image file is input in the processing module 610 of the imaging system 600. In the processing module 610, the following steps are performed:
- receiving of the combined raster image file,
- analysing the image data of the combined raster image file,
- determining control data based on the analysed image data, said control data being data for controlling settings of an imaging device so as to change the physical properties of generated imaged features corresponding with the pixels of the combined raster image file;
- outputting the control data to the imaging device 620 for imaging a relief precursor.

During the imaging the imaging pixels are transferred to the mask layer as ablated spots or spots which undergo a change in transmission for electromagnetic radiation used to cure the photosensitive layer. When the photosensitive layer of the relief precursor plate, covered by the imaged mask layer, undergoes curing for example by electromagnetic radiation, the areas exposed through the imaged spots are cured while the areas covered by the non-imaged parts of the mask layer remain uncured. The photosensitive layer, together with the mask layer is then developed, e.g., treated with a liquid (e.g. solvent or water) in a washing process to wash away the uncured parts of the photosensitive layer and the mask layer, or thermally developed with the aid of a developing material (e.g. a non-woven polymer web). Thus, one obtains a relief plate.

Embodiments of the present application are defined in the following clauses:
Clause 1. A method of determining at least one layout for imaging at least one relief precursor (6), comprising:
   - receiving image job data for at least one image job comprising at least two raster image files (10; 20) having at least two different resolutions (R1, R2) and/or at least two different quality settings requiring different imaging modes (M1, M2);
   - determining, using processing means, at least one layout including the image job data for imaging at least one mask layer of the at least one relief precursor (6), taking into account a total amount of imaging time required to image the at least one mask layer.
Clause 2. The method of clause 1, wherein determining the at least one layout comprises preferring a first direction (C) to arrange raster image files having the same resolution and/or same quality setting to a second direction (L) different from the first direction (C).
Clause 3. The method of the previous clause, wherein the first direction (C) is approximately perpendicular to the second direction (L).
Clause 4. The method of clause 2 or 3, wherein the first direction (C) is the circumferential direction of a drum on which the relief precursor (6) is fixed during imaging.
Clause 5. The method of any of the previous clauses, wherein determining the at least one layout further comprises taking into account the number of relief precursors (6) needed to fit the image job data.
Clause 6. The method of any of the previous clauses, wherein determining the at least one layout further comprises taking into account whether raster image files on a same relief precursor (6) belong to the same image job of said at least one image job.
Clause 7. The method of any of the previous clauses, wherein determining the at least one layout further comprises taking into account a priority or a deadline of an image job of said at least one image job.
Clause 8. The method of any one of the previous clauses, wherein determining the at least one layout comprises minimising the total amount of imaging time required to image the at least one mask layer.
Clause 9. The method of any of the previous clauses, wherein determining the at least one layout comprises using weight factors for two or more of the following criteria: a total amount of imaging time required to image the at least one mask layer, the number of relief precursors (6) needed to fit the image job data, whether raster image files on a same relief precursor (6) belong to the same image job of said at least one image job, a priority or a deadline of an image job of said at least one image job, an amount of waste.
Clause 10. The method of the previous clause, wherein at least one of the weight factors is input to the processing means through a user interface.
Clause 11. The method of any of the previous two clauses, comprising:
   - determining at least two different possible layouts including all of said image job data;
   - allocating a score for each determined layout taking into account the weight factors;
   - choosing the layout having the highest score as the layout for imaging the at least one mask layer.
Clause 12. The method of any of the previous clauses, wherein the determining is done such that a total area taken up by the raster image files on each mask layer of the at least one relief precursor is at least 60%, preferably more than 70%, more preferably more than 80% of the entire printable area of said mask layer.
Clause 13. The method of any of the previous clauses, wherein determining the layout further comprises arranging the raster image files (10C, 10M, 10Y, 10K) of the same image job on at least one pre-determined relief precursor.
Clause 14. The method of the previous clause, wherein the at least one pre-determined relief precursor is a single relief precursor or a number of consecutive relief precursors imaged one after the other.
Clause 15. The method of any of the previous clauses, further comprising imaging the mask layer of a relief precursor (6) according to the determined layout, wherein a first imaging head (50) emitting at least one first ablation beam (52) according to a first imaging mode (M1) and a second imaging head (60) emitting at least one second ablation beam (62) according to a second imaging mode (M2) different from the first imaging mode (M1) image the mask layer of the relief precursor (6) simultaneously.
Clause 16. The method of the previous clause, wherein the imaging mode (M1, M2) defines at least one of the following properties: an intensity of the at least one laser beam, a shape of the at least one laser beam, a size of the at least one laser beams, the total number of laser beams used in an imaging head, scrambling.
Clause 17. A method of determining at least one layout for imaging at least one relief precursor (6), comprising:
   - receiving image job data for at least one image job comprising a plurality of raster image files (100; 200);
   - determining, using processing means, at least one layout including the image job data for imaging at least one mask layer of the at least one relief precursor (6), comprising overlapping at least two of the plurality of raster image files (100; 200) in the layout.
Clause 18. The method of the previous clause, wherein the image job data comprises at least two indication raster image files having a cutting mark (270) associated with the at least two raster image files, wherein the method comprises taking into account the cutting marks (270) for determining the at least one layout, preferably avoiding that the cutting marks (270) of the at least two indication raster image files cross one another.
Clause 19. The method of clause 17 or 18, the at least two raster image files comprising a first raster image file (100) having at least one image area (I) comprising imaging pixels and at least one non-image area (NI) comprising non-imaging pixels, and a second raster image file (200) having at least one image area (I) comprising imaging pixels,
   wherein overlapping the at least two raster image files in the layout comprises avoiding overlapping the image area (I) of the second raster image file (200) with the non-image area (NI) of the first raster image file (100).
Clause 20. The method of clause 18 and 19, wherein the cutting mark is located at an edge of an image area (I) of said at least one image area (I).
Clause 21. The method of clause 19 or 20, wherein the at least one non-image area (NI) comprises a border surrounding the at least one image area (I).
Clause 22. The method of clause 18 and 21, wherein the border comprises the cutting mark.
Clause 23. The method of any of clauses 19 - 22, the second raster image file (200) having at least one non-image area (NI) comprising non-imaging pixels,
   wherein overlapping the at least two raster image files in the layout comprises overlapping the non-image area (NI) of the second raster image file (200) with the non-image area (NI) of the first raster image file (100).
Clause 24. A flexographic printing plate obtained by the method according to any of the previous clauses.
Clause 25. A computer program or computer program product comprising computer executable instructions to control the method, when the program is run on a computer, of any one of clauses 1 - 23.
Clause 26. A digital data storage medium encoding a machine-executable program of instructions to perform any one of the steps of the method of any one of clauses 1 - 23.
Clause 27. A system for manufacturing a relief printing plate, comprising control means for carrying out the method of any of clauses 1 - 23.

Whilst the principles of the invention have been set out above in connection with specific embodiments, it is to be understood that this description is merely made by way of example and not as a limitation of the scope of protection, which is determined by the appended claims.

## Claims

1. A method of determining at least one layout for imaging at least one relief precursor (6), comprising:
- receiving image job data for at least one image job comprising at least two raster image files (10; 20) having at least two different resolutions (R1, R2) and/or at least two different quality settings requiring different imaging modes (M1, M2);
- determining, using processing means, at least one layout including the image job data for imaging at least one mask layer of the at least one relief precursor (6), taking into account a total amount of imaging time required to image the at least one mask layer.

2. The method of claim 1, wherein determining the at least one layout comprises preferring a first direction (C) to arrange raster image files having the same resolution and/or same quality setting to a second direction (L) different from the first direction (C).

3. The method of the previous claim, wherein the first direction (C) is approximately perpendicular to the second direction (L); and/or wherein the first direction (C) is the circumferential direction of a drum on which the relief precursor (6) is fixed during imaging.

4. The method of any of the previous claims, wherein determining the at least one layout further comprises taking into account the number of relief precursors (6) needed to fit the image job data; and/or
wherein determining the at least one layout further comprises taking into account whether raster image files on a same relief precursor (6) belong to the same image job of said at least one image job.

5. The method of any of the previous claims, wherein determining the at least one layout further comprises taking into account a priority or a deadline of an image job of said at least one image job; and/or
wherein determining the at least one layout comprises minimising the total amount of imaging time required to image the at least one mask layer.

6. The method of any of the previous claims, wherein determining the at least one layout comprises using weight factors for two or more of the following criteria: a total amount of imaging time required to image the at least one mask layer, the number of relief precursors (6) needed to fit the image job data, whether raster image files on a same relief precursor (6) belong to the same image job of said at least one image job, a priority or a deadline of an image job of said at least one image job, an amount of waste,
wherein preferably at least one of the weight factors is input to the processing means through a user interface; and/or
preferably the method comprises:
- determining at least two different possible layouts including all of said image job data;
- allocating a score for each determined layout taking into account the weight factors;
- choosing the layout having the highest score as the layout for imaging the at least one mask layer.

7. The method of any of the previous claims, wherein the determining is done such that a total area taken up by the raster image files on each mask layer of the at least one relief precursor is at least 60%, preferably more than 70%, more preferably more than 80% of the entire printable area of said mask layer; and/or
wherein determining the layout further comprises arranging the raster image files (10C, 10M, 10Y, 10K) of the same image job on at least one pre-determined relief precursor, wherein preferably the at least one pre-determined relief precursor is a single relief precursor or a number of consecutive relief precursors imaged one after the other.

8. The method of any of the previous claims, further comprising imaging the mask layer of a relief precursor (6) according to the determined layout, wherein a first imaging head (50) emitting at least one first ablation beam (52) according to a first imaging mode (M1) and a second imaging head (60) emitting at least one second ablation beam (62) according to a second imaging mode (M2) different from the first imaging mode (M1) image the mask layer of the relief precursor (6) simultaneously, wherein preferably the imaging mode (M1, M2) defines at least one of the following properties: an intensity of the at least one laser beam, a shape of the at least one laser beam, a size of the at least one laser beams, the total number of laser beams used in an imaging head, scrambling.

9. A method of determining at least one layout for imaging at least one relief precursor (6), comprising:
- receiving image job data for at least one image job comprising a plurality of raster image files (100; 200);
- determining, using processing means, at least one layout including the image job data for imaging at least one mask layer of the at least one relief precursor (6), comprising overlapping at least two of the plurality of raster image files (100; 200) in the layout.

10. The method of the previous claim, wherein the image job data comprises at least two indication raster image files having a cutting mark (270) associated with the at least two raster image files, wherein the method comprises taking into account the cutting marks (270) for determining the at least one layout, preferably avoiding that the cutting marks (270) of the at least two indication raster image files cross one another.

11. The method of claim 9 or 10, the at least two raster image files comprising a first raster image file (100) having at least one image area (I) comprising imaging pixels and at least one non-image area (NI) comprising non-imaging pixels, and a second raster image file (200) having at least one image area (I) comprising imaging pixels,
wherein overlapping the at least two raster image files in the layout comprises avoiding overlapping the image area (I) of the second raster image file (200) with the non-image area (NI) of the first raster image file (100),
wherein preferably the cutting mark is located at an edge of an image area (I) of said at least one image area (I); and/or
wherein preferably the at least one non-image area comprises a border surrounding the at least one image area (I), more preferably the image job data comprises at least two indication raster image files having a cutting mark (270) associated with the at least two raster image files, wherein the method comprises taking into account the cutting marks (270) for determining the at least one layout, preferably avoiding that the cutting marks (270) of the at least two indication raster image files cross one another and the border comprises the cutting mark; and/or
preferably the second raster image file (200) having at least one non-image area (NI) comprising non-imaging pixels, wherein overlapping the at least two raster image files in the layout comprises overlapping the non-image area (NI) of the second raster image file (200) with the non-image area (NI) of the first raster image file (100).

12. A flexographic printing plate obtained by the method according to any of the previous claims.

13. A computer program or computer program product comprising computer executable instructions to control the method, when the program is run on a computer, of any one of claims 1 - 11.

14. A digital data storage medium encoding a machine-executable program of instructions to perform any one of the steps of the method of any one of claims 1 - 11.

15. A system for manufacturing a relief printing plate, comprising control means for carrying out the method of any of claims 1 - 11.
